# EUROPEAN PATENT APPLICATION

(11) **EP 4 682 600 A1**
(43) Date of publication of application: **21.01.2026**
(21) Application number: 24189878.2
(22) Date of filing: 19.07.2024
(51) Int. Cl.: G02B 6/12, G02B 6/293, H01S 5/0687

(54) **INTEGRATED WAVELENGTH LOCKER**

(71) Applicant: Huawei Technologies Co., Ltd., Shenzhen, Guangdong 518129 (CN)
(72) Inventor: TAILLAERT, Dirk, 80992 Munich (DE); TASSAERT, Martijn, 80992 Munich (DE)
(74) Representative: Grünecker Patent- und Rechtsanwälte PartG mbB

(57) **Abstract**

In some examples, an integrated wavelength locker fabricated on a silicon substrate comprises a first Mach-Zehnder interferometer and a second Mach-Zehnder interferometer, wherein the first Mach-Zehnder interferometer and the second Mach-Zehnder interferometer each comprises an input coupler comprising multiple outputs, an output coupler comprising multiple inputs, a first waveguide formed on the silicon substrate and extending between a first output of the input coupler and a first input of the output coupler, and a second waveguide formed on the silicon substrate and extending between a second output of the input coupler and a second input of the output coupler, wherein the first waveguide is associated with a first length, wherein the second waveguide is associated with a second length, wherein the first length is different from the second length, wherein a difference between the first length and the second length defines a delay length of the first Mach-Zehnder interferometer and the second Mach-Zehnder interferometer, respectively, wherein the first length and/or the second length differs between the first Mach-Zehnder interferometer and the second Mach-Zehnder interferometer.

## Description

### TECHNICAL FIELD

The present disclosure relates, in general, to the field of optical communications. Aspects of the disclosure relate to a wavelength locker.

### BACKGROUND

A multimode interference (MMI) coupler is a passive optical device that exploits the self-imaging principle of multimode waveguides to perform various optical functions. MMIs are widely used in integrated optics and photonic circuits due to their compact size, ease of fabrication, and ability to provide accurate power splitting ratios. In a typical 4x4 MMI coupler, four input ports and four output ports are used to combine and distribute optical signals, making it a versatile component for complex optical networks.

One of the applications of MMI couplers is in a wavelength locker in wavelength division multiplexing (WDM) systems. WDM is a technology that multiplexes multiple optical carrier signals on a single optical fibre by using different wavelengths of laser light to carry different signals. This significantly increases the bandwidth of the optical fibre, allowing for the simultaneous transmission of multiple data channels. The lasers used in WMD typically use a wavelength locker to accurately control the wavelength of the laser. The 4x4 MNΠ coupler is particularly useful in these systems because the phase difference between its outputs is a multiple of 90 degrees. This well-defined phase difference can be used as a reference signal in an integrated wavelength locker.

However, a significant disadvantage of the 4x4 MNΠ coupler is its limited bandwidth. The insertion loss of a 4x4 MNΠ increases as the operational wavelength deviates from the central wavelength. While this limitation is not critical for C-band applications (1530-1565 nm), it becomes a substantial problem for C+L band applications (1530-1625 nm), where a broader range of wavelengths is used. In C+L band applications, the insertion loss at wavelengths farther from the central wavelength can become quite high. When a wavelength locker has higher insertion loss, more optical power from the laser need to be sent to the wavelength locker, so less optical power from the laser is available for the data signal, leading to reduced efficiency and signal degradation.

This limited bandwidth poses a challenge for the implementation of 4x4 MMI couplers in modem optical communication systems that demand high performance across a wide range of wavelengths. As the demand for higher data transmission rates and broader wavelength utilization grows, there is a pressing need for optical components that can maintain low insertion loss over an extended wavelength range. Therefore, addressing the bandwidth limitation of 4x4 MMI couplers is crucial for advancing the capabilities of optical networks and meeting the ever-increasing demands for data transmission and network reliability.

### SUMMARY

An objective of the present disclosure is to provide a wavelength locker with lower insertion loss across a wide bandwidth, enabling flexible wavelength peak selection by design.

The foregoing and other objectives are achieved by the features of the independent claims.

Further implementation forms are apparent from the dependent claims, the description and the Figures.

A first aspect of the present disclosure provides an integrated wavelength locker fabricated on a silicon substrate, the integrated wavelength locker comprising a first Mach-Zehnder interferometer and a second Mach-Zehnder interferometer, wherein the first Mach-Zehnder interferometer and the second Mach-Zehnder interferometer each comprises an input coupler comprising multiple outputs, an output coupler comprising multiple inputs, a first waveguide formed on the silicon substrate and extending between a first output of the input coupler and a first input of the output coupler, and a second waveguide formed on the silicon substrate and extending between a second output of the input coupler and a second input of the output coupler, wherein the first waveguide is associated with a first length, wherein the second waveguide is associated with a second length, wherein the first length is different from the second length, wherein a difference between the first length and the second length defines a delay length of the first Mach-Zehnder interferometer and the second Mach-Zehnder interferometer, respectively, wherein the first length and/or the second length differs between the first Mach-Zehnder interferometer and the second Mach-Zehnder interferometer.

Accordingly, a wavelength locker exhibiting a lower loss for wide bandwidth applications (for example, C+L band applications) can be provided. Advantageously, the present invention provides the ability to choose the delta peak during design. Furthermore, the variance of the delta peak can be minimised, since the delta peak is defined (and thus controlled) during fabrication, without the use of any tuning elements on the chip.

The first waveguide and/or the second waveguide may comprise a silicon nitride waveguide formed on the silicon substrate.

The first waveguide and the second waveguide may each comprise a straight section and a curved section.

The curved section may comprise multiple bends.

The first waveguide and the second waveguide may comprise the same number of bends of the multiple bends.

Each bend of the multiple bends may cause the waveguide to change orientation from a first direction to a direction substantially perpendicular to the first direction.

A length of the straight section of the first waveguide may differ from a length of the straight section of the second waveguide.

The first waveguide and the second waveguide may be U-shaped.

The curved section may comprise a nested length of sinuous wavelength section.

The first waveguide may be arranged adjacent to the second waveguide on the silicon substrate.

The integrated wavelength locker may further comprise a dummy waveguide pattern arranged around the first waveguide and/or the second waveguide on the silicon substrate.

Respective first waveguides of the first Mach-Zehnder interferometer and the second Mach-Zehnder interferometer may be the same as one another, and respective second waveguides of the first Mach-Zehnder interferometer and the second Mach-Zehnder interferometer may be the same as one another.

A delay length of the first Mach-Zehnder interferometer and the second Mach-Zehnder interferometer may comprise a length of around 3 millimetres, and a difference between the delay length of the first Mach-Zehnder interferometer and the second Mach-Zehnder interferometer may comprise a value in a range of around 100 nanometres to around 250 nanometres.

The integrated wavelength locker may further comprise multiple photodiodes coupled to the output coupler of the first Mach-Zehnder interferometer and the second Mach-Zehnder interferometer, respectively.

The integrated wavelength locker may further comprise a power splitter comprising multiple outputs, wherein one of the multiple outputs of the power splitter is connected to a photodiode of the multiple photodiodes, wherein at least two of the multiple outputs of the power splitter are connected to the input coupler of the first Mach-Zehnder interferometer and/or the input coupler of the second Mach-Zehnder interferometer.

These and other aspects of the invention will be apparent from the embodiment(s) described below.

### BRIEF DESCRIPTION OF THE DRAWINGS

In order that the present invention may be more readily understood, embodiments of the invention will now be described, by way of example, with reference to the accompanying drawings, in which:
Figure 1 is a schematic representation of a wavelength locker according to an example;
Figure 2 is a schematic representation of a wavelength locker according to another example;
Figure 3 is a schematic representation of a wavelength locker according to yet another example;
Figure 4 is a graph illustrating a free spectral range (FSR) and delta peak for signals of a first MZI and a second MZI;
Figure 5 is a graph illustrating a delta peak of a device based on the prior art and a delta peak of a device according to the current invention; and
Figure 6 is a graph showing simulation data comparing the insertion loss spectrum of a device according to the prior art and a device according to the current invention.

### DETAILED DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

Today, most long-haul optical communication systems utilise Dense Wavelength Division Multiplexing (DWDM), where multiple wavelength channels (e.g., 96 or 120 channels) are transmitted over a single fibre. Each channel is managed by a transmitter (or transceiver) equipped with a tunable laser source. To ensure wavelength accuracy, a tunable laser is paired with a wavelength locker. A wavelength locker provides a feedback signal for precise adjustment of the laser's emission wavelength. This component is typically housed in the same package as the tunable laser, forming what is known as an Integrated Tunable Laser Assembly (ITLA).

A common implementation of the wavelength locker employs a Fabry-Perot etalon, a free-space component that uses multiple lenses and prisms. Despite being integrated into the laser's package, this solution is not an integrated chip-based solution. A wavelength locker designed as an optical chip or Planar Lightwave Circuit (PLC) or Photonic Integrated Circuit (PIC) can significantly reduce the overall size, offering the advantage of a more compact package.

In DWDM systems, the wavelengths used are defined by the International Telecommunications Union (ITU) in the DWDM frequency grid. This grid specifies a set of frequencies with 12.5 GHz channel spacing, which can be multiples of this value (e.g., 12.5 GHz, 25 GHz, 50 GHz, 100 GHz). Traditional DWDM systems employ a uniform modulation format and bitrate for each channel, necessitating fixed channel spacing (e.g., 50 GHz channel spacing using the 50 GHz ITU grid). However, modem DWDM systems utilise a combination of different modulation formats and bitrates on the same fibre, allowing for variable channel spacing. This flexibility enables channels of different widths (e.g., 50 GHz and 75 GHz) to coexist. The ITU's flexible DWDM grid, also known as gridless, has a nominal central frequency granularity of 6.25 GHz and a slot width granularity of 12.5 GHz. In contrast to fixed grid wavelength lockers that use a single optical filter to provide the feedback signal, flexible grid lockers typically employ two optical filters to generate the feedback signal.

Existing integrated wavelength lockers in silicon photonics commonly feature a single delay line and a 90° hybrid. A "90-degree hybrid" is a structure with four outputs, each having a 90-degree phase difference. A 4x4 MMI is a device that can be used as a 90-degree hybrid. While the terms are often used interchangeably, there are other implementations of a 90-degree hybrid. A 4x4 MMI is sometimes referred to as a 2x4 MMI when only two inputs are used; however, the 2x4 MMI and 4x4 MMI are the same structure. The delay line determines the Free Spectral Range (FSR), and the 90° hybrid generates two signals with a peak spacing of 0.25*FSR. Typical values are a 50 GHz FSR and a 12.5 GHz peak spacing.

A first disadvantage of using a 4x4 Multimode Interference (MMI) coupler is its limited bandwidth. Specifically, the insertion loss of the 4x4 MMI increases as the wavelength moves away from the central wavelength, as shown in later figures. While this is not an issue for C-band applications, it becomes problematic for C+L band applications, where insertion loss can become significantly high. A second disadvantage of using the 4x4 MMI is its fixed peak spacing. There is no simple formula to determine the optimal wavelength locker spectrum, as it depends on various factors such as capture range, calibration method, tuning algorithm, and the linearity and noise of the photodetector and electronics. However, it is generally advantageous to have the delta peak set to a different value than the 90° phase shift (12.5 GHz in the case of a 50 GHz FSR).

While prior art utilising two Mach-Zehnder Interferometers (MZIs) instead of a 4x4 MNΠ avoids the aforementioned disadvantages, it introduces a new issue: controlling the delta peak value is very challenging. The prior art does not provide a solution to this problem, which is a significant limitation in achieving the desired performance in flexible grid DWDM systems.

When using two delay lines, the delta peak can be set by design to any value, equivalent to setting the phase to any value between 0 and 360 degrees. In contrast, when using one delay line and a 90° hybrid, the delta peak is determined by the 90° hybrid, resulting in a fixed 90-degree phase. However, controlling the delta peak during fabrication when using two delay lines is very challenging. Tuning elements like heaters cannot be used in the circuit to control the delta peak, as the circuit itself serves as the reference signal in the wavelength locker application.

According to an example, a wavelength locker capable of reduced loss for wide bandwidth applications, such as those in the C+L band, is provided. An advantageous aspect of the present invention is the ability to specify the delta peak during the design phase. Moreover, variability in the delta peak can be minimised as it is precisely defined and controlled during fabrication, obviating the need for any tuning elements on the chip. This ensures a more stable and reliable performance, thereby enhancing the overall efficiency and effectiveness of the wavelength locker in optical communication systems.

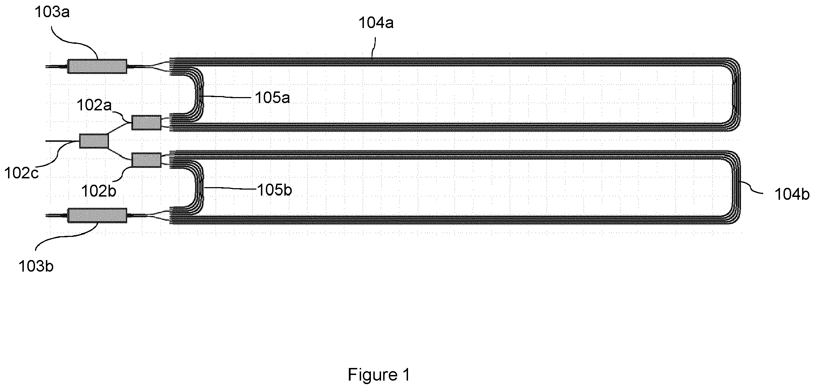

Figure 1 is a schematic representation of a wavelength locker according to an example. In particular, an optical circuit (e.g., an optical filter) of a wavelength locker 100 is shown. The wavelength locker 100 is fabricated on a silicon substrate, such as silicon nitride. However, it should be understood that other silicon-based substrates may also be utilised, including but not limited to silicon dioxide or silicon-on-insulator (SOI). The choice of substrate material is not limited to those explicitly mentioned, and any suitable silicon substrate that supports the necessary optical properties and fabrication processes may be employed.

The wavelength locker 100 comprises a first Mach-Zehnder interferometer 101a and a second Mach-Zehnder interferometer 101b. The terms MZI (Mach Zehnder interferometer), DLI (delay line interferometer) and delay line may be used as synonyms. The term delay line interferometer is more general; however, in integrated optics, the most commonly used DLI is the MZI.

Each one of the first MZI 101a and the second MZI 101b comprises an input coupler comprising multiple outputs and an output coupler comprising multiple inputs. Figure 1 depicts multiple couplers - in particular, a first input coupler 102a, associated with the first MZI 101a, a second input coupler 102b, associated with the second MZI 101b, as well as a common input coupler 102c comprising multiple outputs. The common input coupler 102c may provide input signals to both the first MZI 101a and the second MZI 101b. The outputs of the common input coupler 102c may be connected to the input of the first input coupler 102a and the input of the second input coupler 102b, respectively. Figure 1 also illustrates a first output coupler 103a, associated with the first MZI 101a, and a second output coupler 103b, associated with the second MZI 101b.

Each one of the first MZI 101a and the second MZI 101b comprises a first waveguide 104 formed on the silicon substrate and a second waveguide 105 also formed on the silicon substrate. In Figure 1, the first MZI 101a comprises the first waveguide 104a and the second waveguide 105a, whereas the second MZI 101b comprises the first waveguide 104b and the second waveguide 105b. The first waveguide 104 is formed between a first input of the input coupler 102 and a first output of the output coupler 103. The second waveguide 105 is formed between a second input of the input coupler 102 and a second output of the output coupler 103. For example, referring to the first MZI 101a, the first waveguide 104a may be formed between a first input of the first input coupler 102a and the first output of the output coupler 103a. The first waveguide 104 and the second waveguide 105 may comprise at least one delay line.

The first waveguide 104 and/or the second waveguide 105 may be created using multimode waveguide routing techniques on a suitable silicon substrate, such as silicon nitride (SiN), silicon dioxide (SiO2), or silicon-on-insulator (SOI). The process may involve photolithography to define the waveguide pattern, followed by etching techniques to create the waveguide structure. It should be noted that the specific fabrication methods and materials are not limited to those described and may vary depending on the application requirements and available technology. During fabrication of the first waveguide 104 and/or the second waveguide 105, a dummy waveguide pattern may be employed to improve fabrication uniformity. The dummy waveguide pattern may be arranged around the waveguide on the silicon substrate. The first waveguide 104 may be arranged adjacent to the second waveguide 105 on the substrate.

The first waveguide 104 is associated with a first length and the second waveguide 105 is associated with a second length. The first length is different from the second length. Furthermore, the first length and/or the second length differs between the first MZI 101a and the second MZI 101b. In a particular example, the respective first waveguides 104a and 104b of the first MZI 101a and the second MZI 101b may have the same length, whereas the respective second waveguides 105a and 105b may differ by 100-250 nanometres.

The difference between the first length and the second length defines a delay length of the first MZI 101a and the second MZI 101b, respectively. For example, for the first MZI 101a, the difference between the first length of the first waveguide 104a and the second length of the second waveguide 105a defines the delay length (i.e., Δ1) of the first MZI 101a. Importantly, the delay length introduces a phase shift between the optical signals propagating through the first waveguide 104 and the second waveguide 105, which in turn defines the delta peak.

The delta peak represents the frequency spacing between the peaks in the interference pattern created by the MZI, and it is directly influenced by the delay length. The first length and the second length may vary such that the first length is either greater than or less than the second length, depending on the desired delta peak value. The flexibility in selecting the first length and the second length allows for precise control over the delta peak without the need to employ tuning elements on the chip. Advantageously, delta peak variance can be minimised.

The values of the first length and the second length may be selected based on the required free spectral range. The free spectral range (FSR) is a fundamental parameter in interferometric devices, defining the frequency interval between consecutive resonance peaks or troughs in the transmission spectrum. The FSR determines the spacing of the interference fringes and is critical in designing devices for specific wavelength ranges, as it impacts the device's ability to distinguish between closely spaced wavelengths in applications such as wavelength lockers.

The first waveguide 104 and the second waveguide 105 may comprise multimode waveguides. Multimode waveguides are optical waveguides designed to support multiple propagation modes, or pathways, for light within a single structure. Multimode waveguides are wider than single-mode waveguides, resulting in lower phase noise of the fundamental mode of a multimode waveguide. Importantly, for each one of the MZI 101a and the MZI 101b, using multimode waveguides as the first waveguide 104 and the second waveguide 105 means that each waveguide can efficiently guide light from the input coupler 102, through the delay lines, to the output coupler 103, while maintaining the integrity of the phase of the optical signals.

As shown in the embodiment of Figure 1, the first waveguide 104 and the second waveguide 105 may each comprise a straight section and a curved section. The curved section of the waveguide may comprise multiple bends. In the example of Figure 1, two bends are shown, but the invention is not limited thereto, as will be shown in the later figures. The first waveguide 104 and the second waveguide 105 may comprise the same number of bends. Each bend may cause the waveguide to change its orientation from a first direction to a direction substantially parallel to the first direction, as depicted in the figure. In other words, each bend may comprise a 90-degree turn.

As previously mentioned, the first length (i.e., the length of the first waveguide 104) and/or the second length (i.e., the length of the second waveguide 105) differs between the first MZI 101a and the second MZI 101b. In other words, the length of the first waveguide and/or the second waveguide of the first MZI 101a is different from the length of the first waveguide and/or the second waveguide of the second MZI 101b. That difference may be present in the straight section of the waveguide. Similarly, the difference between the first length and the second length may also be present in the straight section of the waveguide - i.e., a length of the straight section of the first waveguide 104 may be different from a length of the straight section of the second waveguide 105.

The first waveguide 104 and the second waveguide 105 may exhibit different shapes as part of their design. For instance, these waveguides may be configured in various forms such as straight, curved, U-shaped, or other geometries, depending on the specific requirements of the device. It should be understood that the waveguides' shapes are not limited to any particular configuration, and alternative shapes may be employed to optimize performance, minimise signal loss, or achieve other desired operational characteristics within the wavelength locker 100.

In addition to the input coupler 102, the output coupler 103, and the two Mach-Zehnder Interferometers 101a and 101b, the wavelength locker 100 may also include other suitable elements necessary for its function. These elements may comprise a power splitter, which divides the optical signal into multiple paths; photodiodes, which detect the optical signals and convert them into electrical signals for further processing; and various filters, which may be used to select specific wavelengths or remove unwanted spectral components. For example, the photodiodes may be coupled to the output coupler 103 of the first MZI 101a and the second MZI 101b. One of the multiple outputs of the power splitter may be connected to a photodiode, with the remaining two outputs of the power splitter being connected to the input coupler 102a of the first MZI 101a or the input coupler 102b of the second MZI 101b. Additionally, the device may incorporate electronic control circuits for tuning and calibration, as well as thermal management components to maintain stable operation.

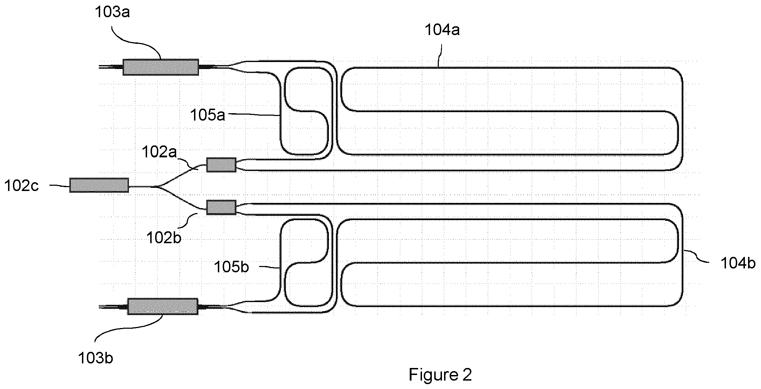

Figure 2 is a schematic representation of a wavelength locker according to another example. Same reference numerals in Figures 1 and 2 denote the same elements which function likewise. The wavelength locker 200 is nearly identical to the wavelength locker 100, with the difference being present in the shape of the first waveguide 104 and the second waveguide 105.

A disadvantage of the embodiment shown in Figure 1 is that the size of the integrated circuit is quite large, and any temperature or stress non-uniformity over the structure can reduce its performance. To address this issue, the embodiment shown in Figure 2 is designed to reduce the area, making it more compact. In comparison to the embodiment shown in Figure 1, the curved section of the waveguide (i.e., first waveguide 104 or the second waveguide 105) comprises more bends. As in the case of the wavelength locker 100, the length difference between the first waveguide 104 and the second waveguide 105 may be present only in the straight section. While in the example of Figure 1 two bends were shown, the example shown in Figure 2 shows eight bends. While the wavelength locker 200 is more compact than the wavelength locker 100, there is no space for a dummy waveguide.

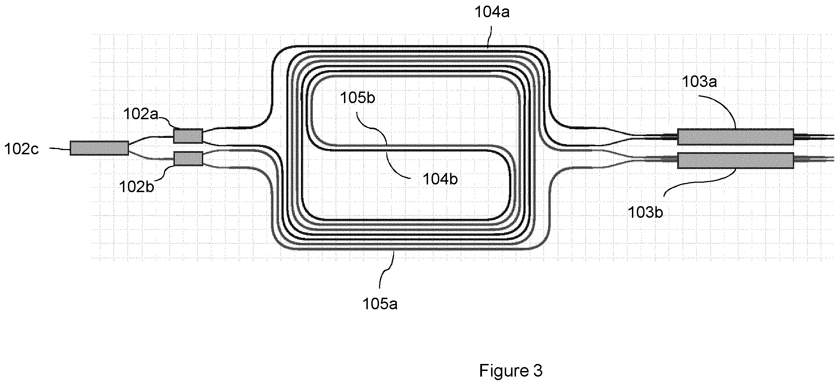

Figure 3 is a schematic representation of a wavelength locker according to another example. Same reference numerals in Figures 1, 2 and 3 denote the same elements which function likewise. The wavelength locker 300 is nearly identical to the wavelength locker 100, once again differing in the shape of the first waveguide 104 and the second waveguide 105. In particular, the first curved section of the first waveguide 104 and/or the second waveguide 105 may comprise a nested length of a sinuous wavelength section, as shown in Figure 3. This design approach significantly reduces the area of the structure, offering the most compact solution.

In the example of Figure 3, in order to keep the local differences to a minimum, every waveguide of the first MZI 101a may be located adjacent to the waveguides of the second MZI 101b. For example, the first waveguide 104a and the second waveguide 105a of the first MZI 101a may be arranged adjacent to the first waveguide 104b and the second waveguide 105b of the second MZI 101b, respectively. Each waveguide may comprise the same number of bends. As in the case of the wavelength lockers 100 and 200, the length difference between the first waveguide 104 and the second waveguide 105 may be present only in the straight section.

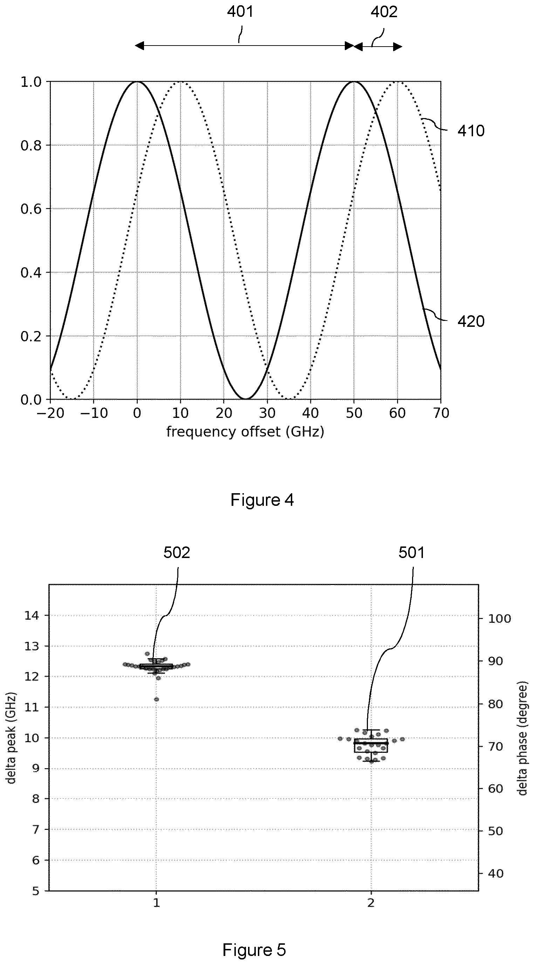

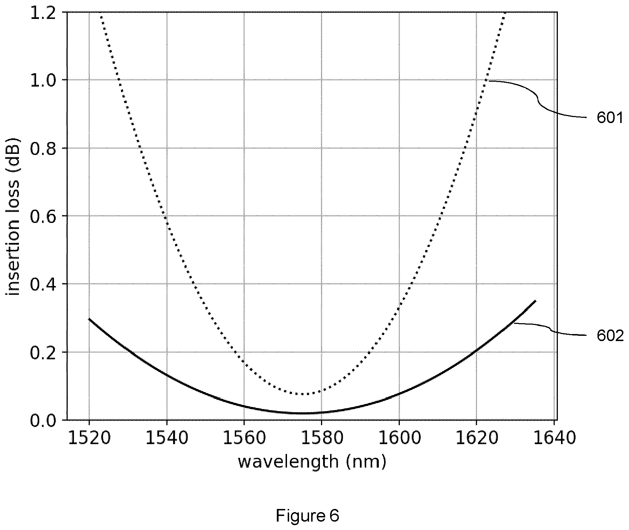

To aid understanding of the invention, reference will now be made to Figures 4-6. Figure 4 is a graph illustrating a free spectral range (FSR) and delta peak for signals of a first MZI and a second MZI. Figure 4 shows the FSR 401 and the delta peak 402 for each one of the signal 420 of the first MZI and the signal 410 of the second MZI. Figure 5 is a graph illustrating a delta peak of a device based on the prior art and a delta peak of a device according to the current invention. The delta peak 502 of the device according to the prior art and the delta peak 501 of the device according to the current invention are shown. The device according to the prior art may comprise a 4x4 MNΠ device. Figure 5 shows that the delta peak can be controlled to a desired value (10 GHz in the example). Figure 6 is a graph showing simulation data comparing the insertion loss spectrum of a device according to the prior art and a device according to the current invention. The device according to the prior art may once again comprise a 4x4 MMI device. In Figure 6, the insertion loss spectrum 601 of the device according to the prior art and the insertion loss spectrum 602 of the device according to the current invention are shown. The insertion loss 601 of the device according to the prior art is higher in C+L band, compared to the lower insertion loss 602 of the present invention.

The preceding description has been provided to enable others skilled in the art to best utilize various aspects of the exemplary embodiments disclosed herein. This exemplary description is not intended to be exhaustive or to be limited to any precise form disclosed. Many modifications and variations are possible without departing from the spirit and scope of the instant disclosure. The embodiments disclosed herein should be considered in all respects illustrative and not restrictive. Reference should be made to the appended claims and their equivalents in determining the scope of the instant disclosure.

## Claims

1. An integrated wavelength locker fabricated on a silicon substrate, the integrated wavelength locker comprising:
a first Mach-Zehnder interferometer (101a) and a second Mach-Zehnder interferometer (101b), wherein the first Mach-Zehnder interferometer (101a) and the second Mach-Zehnder interferometer (101b) each comprises:
an input coupler (102a, 102b) comprising multiple outputs;
an output coupler (103a, 103b) comprising multiple inputs;
a first waveguide (104a, 104b) formed on the silicon substrate and extending between a first output of the input coupler (102a, 102b) and a first input of the output coupler (103a, 103b), and
a second waveguide (105a, 105b) formed on the silicon substrate and extending between a second output of the input coupler (102a, 102b) and a second input of the output coupler (103a, 103b),
wherein the first waveguide (104a, 104b) is associated with a first length, wherein the second waveguide (105a, 105b) is associated with a second length, wherein the first length is different from the second length, wherein a difference between the first length and the second length defines a delay length of the first Mach-Zehnder interferometer (101a) and the second Mach-Zehnder interferometer (101b), respectively,
wherein the first length and/or the second length differs between the first Mach-Zehnder interferometer (101a) and the second Mach-Zehnder interferometer (101b).

2. The integrated wavelength locker of claim 1, wherein the first waveguide (104a, 104b) and/or the second waveguide (105a, 105b) comprises a silicon nitride waveguide formed on the silicon substrate.

3. The integrated wavelength locker of claim 1 or 2, wherein the first waveguide (104a, 104b) and the second waveguide (105a, 105b) each comprises a straight section and a curved section.

4. The integrated wavelength locker of claim 3, wherein the curved section comprises multiple bends.

5. The integrated wavelength locker of claim 4, wherein the first waveguide (104a, 104b) and the second waveguide (105a, 105b) comprise the same number of bends of the multiple bends.

6. The integrated wavelength locker of claim 4 or 5, wherein each bend of the multiple bends causes the waveguide to change orientation from a first direction to a direction substantially perpendicular to the first direction.

7. The integrated wavelength locker of any one of claims 3 to 6, wherein a length of the straight section of the first waveguide (104a, 104b) differs from a length of the straight section of the second waveguide (105a, 105b).

8. The integrated wavelength locker of any one of claims 3 to 7, wherein the first waveguide (104a, 104b) and the second waveguide (105a, 105b) are U-shaped.

9. The integrated wavelength locker of any one of claims 3 to 8, wherein the curved section comprises a nested length of sinuous wavelength section.

10. The integrated wavelength locker of any one of claims 1 to 9, wherein the first waveguide (104a, 104b) is arranged adjacent to the second waveguide (105a, 105b) on the silicon substrate.

11. The integrated wavelength locker of any one of claims 1 to 10, further comprising a dummy waveguide pattern arranged around the first waveguide (104a, 104b) and/or the second waveguide (105a, 105b) on the silicon substrate.

12. The integrated wavelength locker of any one of claims 1 to 11, wherein, respective first waveguides (104a, 104b) of the first Mach-Zehnder interferometer (101a) and the second Mach-Zehnder interferometer (101b) are the same as one another, and wherein respective second waveguides (105a, 105b) of the first Mach-Zehnder interferometer (101 a) and the second Mach-Zehnder interferometer (101b) are the same as one another.

13. The integrated wavelength locker of any one of claims 1 to 11, wherein a delay length of the first Mach-Zehnder interferometer (101a) and the second Mach-Zehnder interferometer (101b) comprises a length of around 3 millimetres, and a difference between the delay length of the first Mach-Zehnder interferometer (101a) and the second Mach-Zehnder interferometer (101b) comprises a value in a range of around 100 nanometres to around 250 nanometres.

14. The integrated wavelength locker of any one of claims 1 to 12, further comprising multiple photodiodes coupled to the output coupler (103a, 103b) of the first Mach-Zehnder interferometer (101a) and the second Mach-Zehnder interferometer (101b), respectively.

15. The integrated wavelength locker of claim 14, further comprising a power splitter comprising multiple outputs, wherein one of the multiple outputs of the power splitter is connected to a photodiode of the multiple photodiodes, wherein at least two of the multiple outputs of the power splitter are connected to the input coupler (102a) of the first Mach-Zehnder interferometer (101a) and/or the input coupler (102b) of the second Mach-Zehnder interferometer (101b).

## Amended claims

### Amended claims in accordance with Rule 137(2) EPC.

1. An integrated wavelength locker fabricated on a silicon substrate, the integrated wavelength locker comprising:
a first Mach-Zehnder interferometer (101a) and a second Mach-Zehnder interferometer (101b), wherein the first Mach-Zehnder interferometer (101a) and the second Mach-Zehnder interferometer (101b) each comprises:
an input coupler (102a, 102b) comprising multiple outputs;
an output coupler (103a, 103b) comprising multiple inputs;
a first waveguide (104a, 104b) formed on the silicon substrate and extending between a first output of the input coupler (102a, 102b) and a first input of the output coupler (103a, 103b), and
a second waveguide (105a, 105b) formed on the silicon substrate and extending between a second output of the input coupler (102a, 102b) and a second input of the output coupler (103a, 103b),
wherein the first waveguide (104a, 104b) is associated with a first length, wherein the second waveguide (105a, 105b) is associated with a second length, wherein the first length is different from the second length, wherein a difference between the first length and the second length defines a delay length of the first Mach-Zehnder interferometer (101a) and the second Mach-Zehnder interferometer (101b), respectively,
wherein the first length and/or the second length differs between the first Mach-Zehnder interferometer (101a) and the second Mach-Zehnder interferometer (101b) and wherein a delta peak is defined and controlled during fabrication, without the use of any tuning elements on the chip.

2. The integrated wavelength locker of claim 1, wherein the first waveguide (104a, 104b) and/or the second waveguide (105a, 105b) comprises a silicon nitride waveguide formed on the silicon substrate.

3. The integrated wavelength locker of claim 1 or 2, wherein the first waveguide (104a, 104b) and the second waveguide (105a, 105b) each comprises a straight section and a curved section.

4. The integrated wavelength locker of claim 3, wherein the curved section comprises multiple bends.

5. The integrated wavelength locker of claim 4, wherein the first waveguide (104a, 104b) and the second waveguide (105a, 105b) comprise the same number of bends of the multiple bends.

6. The integrated wavelength locker of claim 4 or 5, wherein each bend of the multiple bends causes the waveguide to change orientation from a first direction to a direction substantially perpendicular to the first direction.

7. The integrated wavelength locker of any one of claims 3 to 6, wherein a length of the straight section of the first waveguide (104a, 104b) differs from a length of the straight section of the second waveguide (105a, 105b).

8. The integrated wavelength locker of any one of claims 3 to 7, wherein the first waveguide (104a, 104b) and the second waveguide (105a, 105b) are U-shaped.

9. The integrated wavelength locker of any one of claims 3 to 8, wherein the curved section comprises a nested length of sinuous wavelength section.

10. The integrated wavelength locker of any one of claims 1 to 9, wherein the first waveguide (104a, 104b) is arranged adjacent to the second waveguide (105a, 105b) on the silicon substrate.

11. The integrated wavelength locker of any one of claims 1 to 10, further comprising a dummy waveguide pattern arranged around the first waveguide (104a, 104b) and/or the second waveguide (105a, 105b) on the silicon substrate.

12. The integrated wavelength locker of any one of claims 1 to 11, wherein a delay length of the first Mach-Zehnder interferometer (101a) and the second Mach-Zehnder interferometer (101b) comprises a length of around 3 millimetres, and a difference between the delay length of the first Mach-Zehnder interferometer (101a) and the second Mach-Zehnder interferometer (101b) comprises a value in a range of around 100 nanometres to around 250 nanometres.

13. The integrated wavelength locker of any one of claims 1 to 11, further comprising multiple photodiodes coupled to the output coupler (103a, 103b) of the first Mach-Zehnder interferometer (101a) and the second Mach-Zehnder interferometer (101b), respectively.

14. The integrated wavelength locker of claim 13, further comprising a power splitter comprising multiple outputs, wherein one of the multiple outputs of the power splitter is connected to a photodiode of the multiple photodiodes, wherein at least two of the multiple outputs of the power splitter are connected to the input coupler (102a) of the first Mach-Zehnder interferometer (101a) and/or the input coupler (102b) of the second Mach-Zehnder interferometer (101b).
